(19) Europäisches Patentamt / European Patent Office / Office européen des brevets

(11) **EP 2 896 076 B1**

(12) **FASCICULE DE BREVET EUROPEEN**

(45) Date de publication et mention de la délivrance du brevet:
**01.06.2016 Bulletin 2016/22**

(21) Numéro de dépôt: **13774465.2**

(22) Date de dépôt: **16.09.2013**

(51) Int Cl.:
**H01L 31/18** *(2006.01)*

(86) Numéro de dépôt international:
**PCT/FR2013/000241**

(87) Numéro de publication internationale:
**WO 2014/041261 (20.03.2014 Gazette 2014/12)**

(54) **DISPOSITIF ET PROCÉDÉ DE RESTAURATION DES CELLULES SOLAIRES À BASE DE SILICIUM AVEC TRANSDUCTEUR ULTRASON**

VORRICHTUNG UND VERFAHREN ZUR WIEDERHERSTELLUNG VON FOTOVOLTAIKSOLARZELLEN AUF SILICIUMBASIS UNTER VERWENDUNG EINES ULTRASCHALLWANDLERS

DEVICE AND METHOD FOR RESTORING SILICON-BASED PHOTOVOLTAIC SOLAR CELLS USING AN ULTRASOUND TRANSDUCER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.09.2012 FR 1202455**

(43) Date de publication de la demande:
**22.07.2015 Bulletin 2015/30**

(73) Titulaire: **Commissariat à l'Énergie Atomique et aux Énergies Alternatives 75015 Paris (FR)**

(72) Inventeurs:
• **DUBOIS, Sébastien** F-74950 Scionzier (FR)
• **ENJALBERT, Nicolas** F-81100 Burlats (FR)
• **GARANDET, Jean-Paul** 92210 Saint-Cloud (FR)
• **GIDON, Pierre** F-38130 Echirolles (FR)
• **TANAY, Florent** F-38000 Grenoble (FR)
• **VEIRMAN, Jordi** F-74330 Poisy (FR)

(74) Mandataire: **Talbot, Alexandre Cabinet Hecké Europole 10, rue d'Arménie - BP 1537 38025 Grenoble Cedex 1 (FR)**

(56) Documents cités:
**EP-A2- 1 054 457    WO-A1-2007/107351 JP-A- 2011 243 687    US-A1- 2010 200 060 US-B2- 8 136 478**

• **JI YOUN LEE: "Rapid Thermal Processing of Silicon Solar Cells-Passivation and Diffusion", 1 janvier 2003 (2003-01-01), DISSERTATION,, PAGE(S) 1 - 30, XP002439621, page 35, ligne 1 - ligne 8 page 65, ligne 1 - dernière ligne**
• **GLUNZ S W ET AL: "STABLE CZOCHRALSKI SILICON SOLAR CELLS USING GALLIUM-DOPED BASE MATERIAL", 16TH. E.C. PHOTOVOLTAIC SOLAR ENERGY CONFERENCE. GLASCOW, UNITED KINGDOM, MAY 1 - 5, 2000; [PROCEEDINGS OF THE INTERNATIONAL PHOTOVOLTAIC SOLAR ENERGY CONFERENCE], LONDON : JAMES & JAMES LTD, GB, vol. CONF. 16, 1 mai 2000 (2000-05-01), pages 1070-1075, XP001138823, ISBN: 978-1-902916-18-7**

- **REIN S ET AL: "ANALYSIS OF THE HIGH-TEMPERATURE IMPROVEMENT OF CZ-SILICON", 16TH. E.C. PHOTOVOLTAIC SOLAR ENERGY CONFERENCE. GLASCOW, UNITED KINGDOM, MAY 1 - 5, 2000; [PROCEEDINGS OF THE INTERNATIONAL PHOTOVOLTAIC SOLAR ENERGY CONFERENCE], LONDON : JAMES & JAMES LTD, GB, vol. CONF. 16, 1 mai 2000 (2000-05-01), pages 1201-1205, XP001138854, ISBN: 978-1-902916-18-7**

**Description**

**Domaine technique de l'invention**

L'invention est relative à un dispositif et un procédé destinés à supprimer les effets de dégradation du rendement sous éclairement des cellules solaires photovoltaïques à base de silicium.

**État de la technique**

Les cellules solaires photovoltaïques réalisées à partir de substrats en silicium amorphe (a-Si), monocristallin (sc-Si) ou multicristallin (mc-Si), peuvent souffrir d'un effet de dégradation du rendement sous éclairement. Ce phénomène survient lors des premières utilisations des cellules solaires photovoltaïques, et il est usuellement appelé, effet «LID» (LID pour l'abréviation anglaise de « Light-Induced-Degradation »). Les mécanismes physiques à l'origine de cette dégradation du rendement des cellules solaires photovoltaïques sous éclairement, restent néanmoins mal connus. Par ailleurs, quelques études scientifiques ont montré que des éléments légers présents dans le silicium, notamment les atomes d'hydrogène (H), de bore (B) et d'oxygène (O) participent généralement à la formation et à l'activation de défauts lors de l'éclairement des cellules solaires photovoltaïques.

Les effets «LID» peuvent être supprimés en injectant des porteurs de charges dans les cellules solaires photovoltaïques tout en chauffant lesdites cellules. La demande internationale WO 2007/107351 divulgue un procédé visant une stabilisation du rendement des cellules solaires photovoltaïques lors de l'éclairement. Dans ce document, le procédé de restauration des cellules comporte une étape d'injection de porteurs de charge via un éclairement ou une polarisation en direct de la cellule solaire photovoltaïque, et une étape de chauffage du substrat à une température comprise entre 50 °C et 230°C. Ce procédé de restauration a permis à la cellule solaire photovoltaïque traitée, de retrouver des performances stables sous des conditions normales de fonctionnement. Les effets de restauration ne prennent place que si la température des cellules solaires photovoltaïques ne dépasse pas une certaine température-limite qui est typiquement de l'ordre de 200 °C voire une température encore plus basse. En effet, les performances de certaines cellules solaires photovoltaïques à base de silicium peuvent être affectées lorsqu'elles sont maintenues à des températures supérieures à 150°C.

En outre, le procédé décrit dans le document cité ci-dessus, nécessite des temps de traitement très élevés pour une restauration complète des cellules solaires photovoltaïques. Par temps de traitement, on entend la durée au cours de laquelle les cellules solaires sont maintenues à une certaine température lors de la génération de porteurs de charge dans les cellules. Les temps de traitement, selon le procédé décrit dans ce document, peuvent atteindre des dizaines voire une centaine d'heures, ce qui rend ce procédé incompatible avec les procédés industriels classiques de fabrication des cellules solaires photovoltaïques.

En effet, des traitements ont été réalisés, selon le procédé décrit dans ce document, pour restaurer des cellules solaires réalisées à partir de substrats en silicium purifiés par voie métallurgique. Pour ce type de cellules solaires, les mécanismes de restauration ont nécessité entre 10 et 40 heures pour des températures élevées comprises entre 150 et 180°C.

Par ailleurs, la cinétique de restauration des cellules solaires photovoltaïques peut être accélérée en augmentant la quantité de porteurs de charge injectée dans la cellule solaire photovoltaïque traitée. Cette augmentation peut être réalisée notamment en augmentant, la puissance de l'éclairement incident ou l'intensité du courant électrique injecté dans la cellule. Il s'est avéré qu'une telle augmentation entraîne une élévation de la température de la cellule solaire photovoltaïque, limitant ou supprimant les effets de la restauration de la cellule solaire photovoltaïque.

La demande de modèle d'utilité CN201450015 décrit un dispositif permettant de chauffer et d'éclairer des cellules solaires à base de silicium pour les restaurer. Le dispositif comporte un système de ventilateurs pour refroidir les cellules solaires photovoltaïques lors du traitement. Cependant, l'utilisation d'un système à base de ventilateurs ne permet pas l'obtention de cellules solaires de bonne qualité. Notamment, il a été observé que ce type de dispositif peut engendrer des problèmes de contraintes mécaniques, créant ainsi des microfissures dans les cellules solaires photovoltaïques.

**Objet de l'invention**

Il existe un besoin de prévoir un dispositif efficace pour restaurer efficacement les cellules solaires photovoltaïques à base de silicium contre la dégradation du rendement sous éclairement tout en préservant l'intégrité mécanique et les performances photovoltaïques des cellules traitées.

On tend à satisfaire ce besoin en prévoyant un dispositif de restauration d'au moins une cellule solaire photovoltaïque à base de silicium, comportant une source de chaleur configurée pour chauffer la cellule solaire photovoltaïque, et des moyens de génération de porteurs de charge dans la cellule solaire photovoltaïque. En outre, le dispositif comporte un transducteur ultrason destiné à générer des ondes ultrasonores se propageant dans la cellule solaire photovoltaïque.

Avantageusement, le dispositif comporte des éléments configurés pour réguler la température de la cellule solaire photovoltaïque à une valeur ou une plage de température cible comprise dans l'intervalle de température de 50 °C - 230 °C. En outre, les éléments de régulation de la température de la cellule solaire photovoltaïque comprennent, avantageusement, une cuve destinée à être remplie par un liquide, et un support de la cellule solaire photovoltaïque configuré pour la disposer dans le liquide.

Par ailleurs, la cuve comporte, de manière avantageuse, un régulateur de la température du liquide configuré pour réguler la température de la cellule solaire photovoltaïque à la valeur ou la plage de température cible.

On prévoit également un procédé de restauration d'au moins une cellule solaire photovoltaïque à base de silicium contre la dégradation du rendement sous éclairement, comportant les étapes suivantes :

- chauffer la cellule solaire photovoltaïque ;
- générer des porteurs de charge dans la cellule solaire photovoltaïque ; et
- générer un régime d'ondes ultrasonores stationnaire dans la cellule solaire photovoltaïque.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- les figures 1, 3 à 6, 8 et 9 illustrent schématiquement, en coupe, des dispositifs selon différents modes de réalisation ;
- la figure 2 illustre schématiquement, une vue de dessus d'un dispositif selon un mode particulier de réalisation ; et
- les figures 7A et 7B illustrent schématiquement et respectivement, une vue de dessus et une vue de côté du dispositif de la figure 6.

## Description de modes préférentiels de réalisation

Le dispositif de restauration de cellules solaires photovoltaïques à base de silicium décrit ci-après diffère de l'art antérieur notamment en ce qu'il prévoit des éléments permettant la génération d'un régime d'ondes ultrasonores stationnaire dans les cellules à traiter, pour augmenter la cinétique de restauration des cellules traitées.

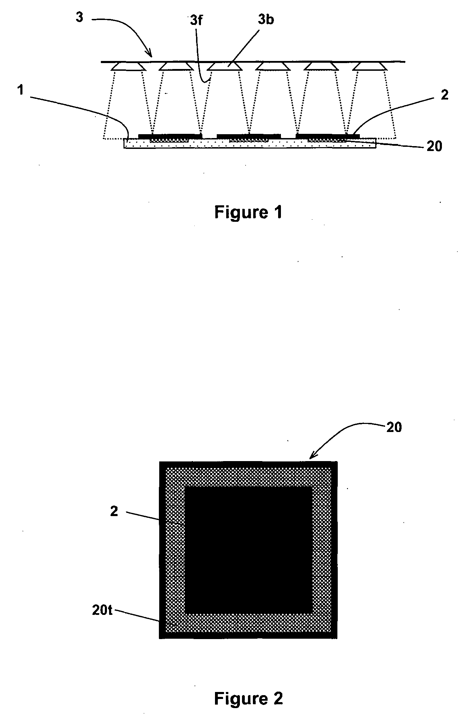

Selon un mode particulier de réalisation illustré à la figure 1, un dispositif de restauration de cellules solaires photovoltaïques à base de silicium comporte un support 1 d'au moins une cellule solaire photovoltaïque 2. Le dispositif de restauration comporte également des moyens de génération 3 de porteurs de charge dans la cellule solaire photovoltaïque 2, et une source de chaleur (non représentée) configurée pour chauffer la cellule solaire photovoltaïque 2. Préférentiellement, la source de chaleur est configurée pour chauffer la cellule solaire photovoltaïque 2 à une température comprise entre 50 °C et 230 °C. Avantageusement, le dispositif comporte des éléments configurés pour contrôler et réguler la température de la cellule solaire photovoltaïque 2 à une valeur ou une plage de température cible, comprise dans l'intervalle de température de 50 °C - 230 °C.

Les moyens de génération 3 de porteurs de charges peuvent, par exemple, comporter une source lumineuse éclairant la cellule solaire photovoltaïque 2 ou des moyens d'injection d'un courant électrique dans la cellule solaire photovoltaïque 2. Autrement dit, les moyens de génération 3 de porteurs de charge dans la cellule solaire photovoltaïque 2, comportent des moyens d'injection d'un courant électrique dans ladite cellule 2. À titre d'exemple, les moyens d'injection peuvent comporter des pointes, reliées à une source de différence de potentiel. Lesdites pointes sont configurées pour entrer en contact avec la cellule solaire photovoltaïque 2 pour y injecter un courant électrique.

Sur la figure 1, les moyens de génération 3 de porteurs de charge sont représentés comme étant une source lumineuse 3b, éclairant la cellule solaire photovoltaïque 2 par un faisceau lumineux 3f. Les moyens de génération 3 de porteurs de charge peuvent également constituer la source de chaleur du dispositif de restauration. À titre d'exemple, des lampes halogènes peuvent constituer à la fois les moyens de génération de porteurs de charge et la source de chaleur:

Le dispositif de restauration permet de chauffer la cellule solaire photovoltaïque 2 tout en y injectant des porteurs de charge, pour restaurer ladite cellule des effets de dégradation du rendement sous l'éclairement. Afin d'augmenter l'efficacité de la restauration et accélérer sa cinétique, le dispositif comporte au moins un transducteur ultrason 20 configuré pour générer un régime d'ondes ultrasonores stationnaire se propageant dans la cellule solaire photovoltaïque 2. Préférentiellement, le transducteur ultrason génère des ondes ultrasonores ayant une fréquence comprise entre 10 et 3000 kHz, et une puissance de quelques $W.cm^{-2}$, typiquement une puissance comprise entre 0,1 et 80 $W.cm^{-2}$.

La propagation des ondes ultrasonores dans la cellule solaire photovoltaïque favorise, de manière avantageuse, les effets de diffusion, réorientation et dissociation des défauts et complexes d'impuretés. Par ailleurs, le dispositif de restauration permet de conjuguer les effets, d'une génération de porteurs de charge dans la cellule solaire photovoltaïque, d'un réchauffement avantageusement contrôlé et régulé de ladite cellule, et d'une génération d'ondes ultrasonores dans la cellule. Ainsi, cette conjugaison de ces effets permet avantageusement d'augmenter la cinétique de restauration de la cellule solaire photovoltaïque et ainsi une réduction du temps de traitement des cellules solaires photovoltaïques.

Avantageusement, le transducteur ultrason 20 est interposé entre le support 1 et la cellule solaire photovoltaïque 2. Cette disposition permet d'obtenir une meilleure propagation des ondes ultrasonores, générées par le transducteur 20, dans la cellule solaire photovoltaïque 2. De manière analogue, la source de chaleur est avantageusement disposée dans le support 1, ce qui permet une diffusion et un contrôle efficaces de la température de la cellule solaire photovoltaïque. À titre d'exemple, la source de chaleur peut comporter des résistances électriques chauffantes, ou des dispositifs thermoélectriques placés dans le support 1.

Selon un mode de réalisation particulier illustré à la figure 2, le transducteur ultrason 20 est conformé de manière à recevoir la cellule solaire photovoltaïque 2. Autrement dit, le transducteur 20 est configuré de manière à ce qu'il soit en contact direct avec la cellule solaire photovoltaïque 2, afin que cette dernière puisse être directement disposée sur le transducteur ultrason 20. Dans ce cas de figure, le transducteur ultrason 20 agit comme un support de la cellule solaire photovoltaïque 2, et il se substitue ainsi au support 1. Préférentiellement, la surface de transmission 20t des ondes ultrasonores dudit transducteur 20 est carrée, et elle comporte toute la surface de contact entre la cellule solaire photovoltaïque 2 et le transducteur ultrason 20. Par surface de transmission, on entend une surface géométrique dont chaque point permet de transmettre une onde ultrasonore ayant un vecteur d'onde perpendiculaire à ladite surface en ce point. Avantageusement, le transducteur ultrason 20 est configuré de manière à ce que l'énergie reçue par la cellule solaire photovoltaïque 2 soit de l'ordre de quelques W.cm$^{-2}$, typiquement une énergie reçue comprise entre 0,1 et 10 W.cm$^{-2}$. Ainsi, le transducteur ultrason 20 est avantageusement choisi de manière à ce qu'il ait une puissance comprise entre 0,1 et 10 W.cm$^{-2}$.

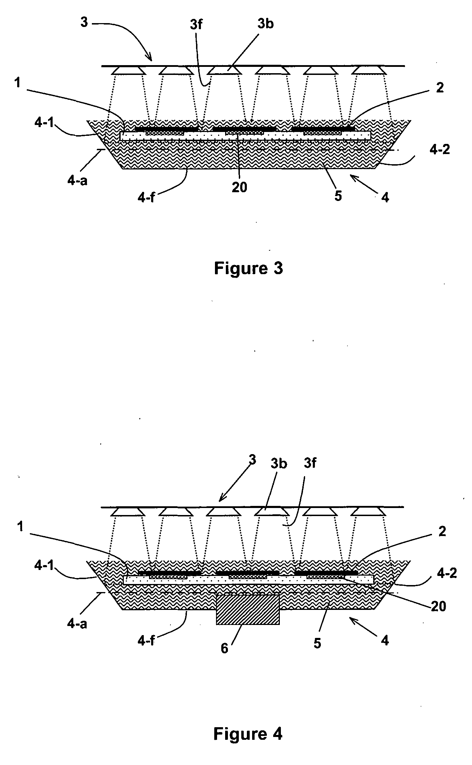

Selon un mode de réalisation particulier illustré à la figure 3, les éléments configurés pour réguler la température de la cellule solaire photovoltaïque 2 comportent une cuve 4 destinée à être remplie par un liquide 5 permettant de réguler la température de la cellule solaire photovoltaïque 2 à une valeur ou une plage de température cible, comprise dans l'intervalle de température 50 °C -230 °C. En outre, le support 1 est configuré pour disposer la cellule solaire photovoltaïque 2 dans le liquide 5. Celle-ci est, en particulier, totalement immergée dans le liquide 5. La cuve 4 comporte un fond 4-f et des parois latérales. Dans un mode de réalisation particulier, les parois latérales comportent une première paroi latérale 4-1 disposée au niveau d'une première extrémité de la cuve 4, et une seconde paroi latérale 4-2 disposée au niveau d'une seconde extrémité opposée à la première extrémité selon un axe longitudinal 4-a de défilement desdites cellules 2.

La disposition de la cellule solaire photovoltaïque 2 dans le liquide 5, permet une dissipation efficace et homogène d'une élévation de la température de ladite cellule 2, notamment lors de l'injection de porteurs de charge. Une forte injection de porteurs de charge permet une accélération de la cinétique de restauration, et ainsi une réduction du temps de traitement des cellules solaires photovoltaïques. Grâce au liquide 5 submergeant la cellule solaire photovoltaïque 2, l'élévation de la température, générée par la quantité de porteurs de charge injectée, est efficacement dissipée, ce qui permet d'obtenir une régulation de la température de la cellule solaire photovoltaïque 2, tout en évitant des problèmes de contraintes thermomécaniques. C'est ainsi que le dispositif de restauration muni du transducteur ultrason 20 et de la cuve 4 permet avantageusement à la fois de relâcher la contrainte sur une augmentation de la génération de porteurs de charge, et d'utiliser les ondes ultrasonores pour réaliser une restauration rapide et efficace des cellules solaires photovoltaïques à base de silicium, tout en préservant l'intégrité mécanique desdites cellules. De plus, la génération des ondes ultrasonores stationnaires favorise le brassage du liquide 5.

Selon un mode de réalisation particulier illustré à la figure 4, la cuve 4 du dispositif de restauration comporte un régulateur 6 de la température du liquide 5. À titre d'exemple, le régulateur 6 peut comporter des dispositifs thermoélectriques disposés dans les parois de la cuve 4, et commandés par un circuit de commande non représenté sur la figure 3.

Le régulateur 6 permet de contrôler avec précision la température du liquide 5 dans la cuve 4, et ainsi la température de la cellule solaire photovoltaïque 2. De ce fait, le régulateur 6 permet de réguler la température de la cellule solaire photovoltaïque 2 à une valeur de température ou dans une gamme de températures cible, lors de l'injection de porteurs de charge. Avantageusement, le régulateur 6 de la température du liquide 5 est configuré pour réguler la température la cellule solaire photovoltaïque 2 à une valeur (par exemple à 170 °C) ou une plage de température cible (par exemple entre 120 °C et 190 °C), comprise dans l'intervalle de température 50 °C - 230 °C. Autrement dit, que la régulation concerne une valeur donnée de température ou une plage de température, la valeur ou la plage de température reste avantageusement comprise dans l'intervalle de température 50°C - 230°C. Pour des cellules solaires photovoltaïques à base de silicium, l'effet de restauration est maximal lorsque la température de la cellule est comprise dans cet intervalle de température. La gamme de température 50 °C - 230 °C permet ainsi d'obtenir une restauration rapide et efficace de la cellule solaire photovoltaïque 2, des effets de dégradation du rendement sous éclairement, tout en préservant les performances photovoltaïques desdites cellules.

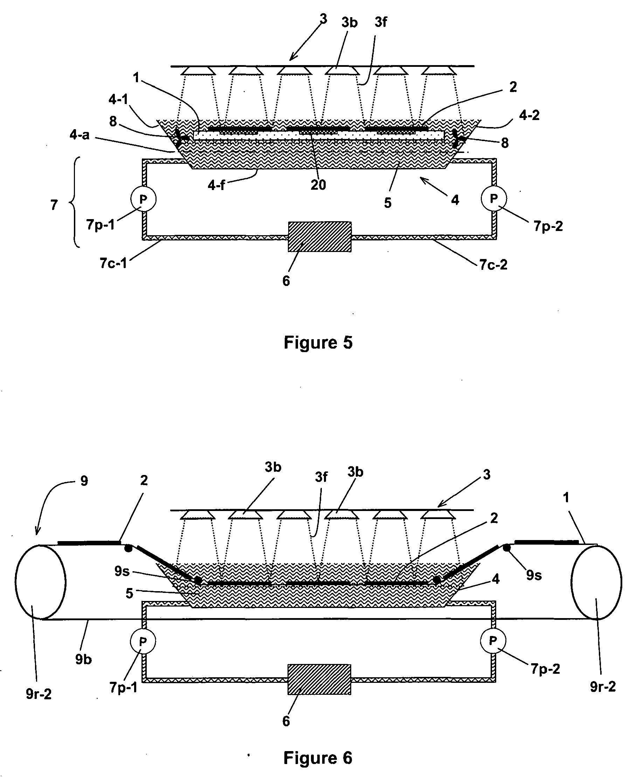

Dans un mode de réalisation particulier illustré à la figure 5, la cuve 4 comporte un système de mise en circulation 7 du liquide 5 dans la cuve 4.

Préférentiellement, les moyens de mise en circulation 7 du liquide 5 comporte des premier 7c-1 et deuxième 7c-2 conduits reliés l'un à l'autre, à l'une de leur extrémité. Le premier conduit 7c-1 peut être connecté à la cuve 4 via un orifice formé dans la première paroi latérale 4-1. Le second conduit est connecté à la cuve 4 via un orifice formé, de manière préférentielle, dans la deuxième paroi latérale 4-2. Afin de faire circuler le liquide 5 dans la cuve 4, le premier conduit 7c-1 peut comporter, par exemple, une première pompe 7p-1 configurée pour aspirer le liquide 5 de la cuve 4 vers le deuxième conduit 7c-2, qui comporte une deuxième pompe 7p-2. La deuxième pompe 7p-2 est configurée pour injecter le liquide 5 dans la cuve 4. Cette configuration des premiers 7c-1 et deuxième 7c-2 conduits permet une circulation du liquide 5 dans la cuve 4 suivant l'axe longitudinal 4-a.

Une circulation du liquide 5 dans la cuve 4 permet avantageusement, une meilleure homogénéisation de la température du liquide 5 dans la cuve 4, ce qui permet une meilleure dissipation de la chaleur de la cellule solaire photovoltaïque 2 vers le liquide 5. De manière avantageuse, le système de mise en circulation 7 est connecté au régulateur de la température 6 du liquide 5. Suivant ce mode de réalisation, le régulateur de la température 6 est configuré de manière à contrôler la température du liquide 5 injecté dans la cuve 4 via le deuxième conduit 7c-2. Préférentiellement, le circuit de commande du régulateur de la température 6 contrôle également les première 7p-1 et deuxième 7p-2 pompes. Avantageusement, le circuit de commande est configuré pour définir la température de la cellule solaire photovoltaïque 2, ou une plage de température autorisée pour la cellule 2.

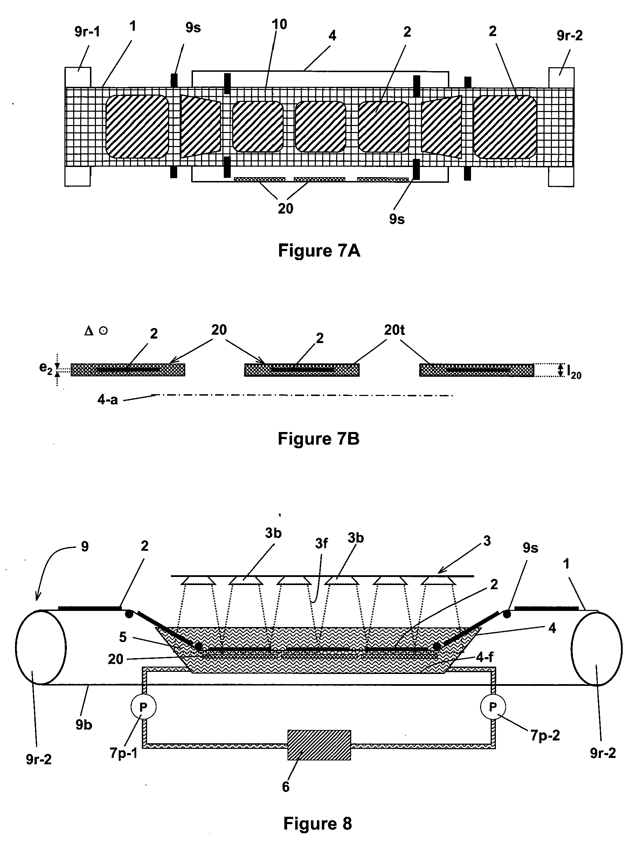

Selon un mode de réalisation illustré aux figures 6, 7A et 7B, le dispositif de restauration comporte un dispositif de déplacement 9 du support 1 dans la cuve 4. Le dispositif de déplacement 9 est configuré pour déplacer la cellule solaire photovoltaïque 2 suivant une direction parallèle à la surface du liquide 5 dans la cuve 4. Le support 1 est conformé de manière à assurer un maintien stable des cellules solaires photovoltaïques 2 sur sa surface. Le dispositif de déplacement 9 du support 1 peut être de type tapis roulant. De préférence, le dispositif de déplacement 9 peut comporter des premier 9r-1 et deuxième 9r-2 rouleaux principaux, autour desquels le support 1 est enroulé pour former une boucle fermée 9b. En outre, le dispositif de déplacement 9 comporte des rouleaux secondaires 9s configurés pour modifier l'axe de translation du support 1 lors de son déplacement suivant le chemin de la boucle fermée 9b. Comme illustré à la figure 7A, les rouleaux secondaires 9s sont en contact uniquement avec les bords du support 1. Cette disposition permet d'éviter tout contact entre les rouleaux secondaires 9s et les cellules solaires photovoltaïques 2 lors du déplacement du support 1. Par ailleurs, au moins un des deux rouleaux principaux 9r-1 et 9r-2 est un rouleau moteur, configuré pour faire déplacer le support 1 en suivant le chemin de la boucle fermée 9b.

Cette configuration du dispositif de restauration permet ainsi une restauration accélérée de plusieurs cellules solaires photovoltaïques disposées, par exemple les unes à la suite des autres ou bien côte à côte, sur le support 1 roulant. Le dispositif de restauration peut ainsi intégrer facilement une chaîne de production à grande échelle.

De préférence, le premier rouleau principal 9r-1 est un rouleau libre, et le deuxième rouleau principal 9r-2 est un rouleau moteur, configuré pour obtenir un sens de déplacement du support 1, opposé au sens de déplacement du liquide 5 dans la cuve 4. Ces déplacements opposés du support 1 et du liquide 5, permettent alors une meilleure dissipation de la chaleur depuis les cellules solaires photovoltaïques 2 vers le liquide 5 et favorisent le brassage du liquide 5.

Avantageusement, le transducteur ultrason 20 est disposé dans la cuve 4 de manière à établir un régime d'ondes ultrasonores stationnaires dans le liquide 5. Préférentiellement, le transducteur ultrason 20 est disposé dans la cuve de manière à être le plus proche possible de la cellule solaire photovoltaïque 2 à traiter. Pour ne pas perturber la propagation des ondes ultrasonores vers la cellule solaire photovoltaïque 2, le transducteur ultrason 20 est préférentiellement disposé de manière à éviter tout obstacle solide, tel que le support 1, entre le transducteur ultrason 20 et ladite cellule 2. Comme illustré à la figure 7A, le transducteur ultrason 20 est disposé, de manière avantageuse, dans une paroi de la cuve 4 de manière à être en vis-à-vis du bord du support 1, et de la cellule solaire photovoltaïque 2. Ainsi, lors du défilement du support 1 dans la cuve, la cellule solaire photovoltaïque défile en face du transducteur ultrason 20. Cette disposition avantageuse permet à toutes les zones de la cellule solaire photovoltaïque 2 d'être balayées par les ondes ultrasonores de manière homogène. De manière avantageuse, et comme illustré à la figure 7B, le transducteur ultrason 20 a une forme rectangulaire, et il comporte une surface de transmission 20t des ondes ultrasonores ayant une largeur $l_{20}$ supérieure à l'épaisseur $e_2$ de la cellule solaire photovoltaïque 2. La direction $\Delta$ des vecteurs d'onde ultrasonore, est alors sensiblement perpendiculaire au bord de la cellule solaire photovoltaïque 2, autrement dit perpendiculaire à l'axe longitudinal 4-a.

En outre, le transducteur ultrason 20 permet avantageusement la génération d'un mouvement de convection dans le liquide 5, conduisant ainsi à un brassage du liquide et une homogénéisation de sa température. Ainsi, ce mode particulier de réalisation, permet avantageusement, à la fois une meilleure régulation de la température de la cellule solaire photovoltaïque à traiter, et la génération d'un régime d'ondes ultrasonores stationnaire dans ladite cellule.

La cuve 4 peut également comporter un circuit de brassage mécanique du liquide 5 dans la cuve 4. Préférentiellement, ce circuit de brassage est associé au dispositif de mise en circulation 7 du liquide 5 dans la cuve 4. Le circuit de brassage peut comporter au moins une hélice 8 disposée dans la cuve 4, par exemple sur l'une des parois latérales.

Selon un mode de réalisation illustré à la figure 7A, le support 1 comporte des trous traversants 10 de manière à ce que le liquide 5 soit en contact avec la face de la cellule solaire photovoltaïque 2 disposée sur le support 1. Cette configuration du support 1 permet d'augmenter la surface de contact entre les cellules solaires photovoltaïques 2 et le liquide 5, lorsque celles-ci sont noyées dans la cuve 4. Dès lors, l'augmentation de la surface de contact entre le liquide 5 et les cellules solaires photovoltaïques permet avantageusement d'assurer de meilleurs échanges thermiques entre les cellules solaires photovoltaïques 2 et le liquide 5. Par ailleurs, il est également avantageux que le support 1 soit à base d'un matériau ayant une conductivité thermique $\lambda_s$ supérieure à la conductivité thermique de la cellule solaire photovoltaïque $\lambda_c$. De préférence, le support 1 est constitué de mailles souples en acier inoxydable.

Selon un mode de réalisation particulier illustré à la figure 8, le dispositif de restauration comporte un dispositif de déplacement 9 du support 1 dans la cuve 4, et avantageusement le transducteur ultrason 20 est disposé sous le support 1. Autrement dit, le transducteur ultrason 20 est interposé entre le fond de la cuve 4-f et le support 1.

Avantageusement, le dispositif de restauration comporte un circuit de commande général (non illustré aux figures) configuré pour commander :

- les moyens de génération 3 de porteurs de charges injectés dans la cellule solaire photovoltaïque 2 ;
- le transducteur ultrason 20 ; et
- avantageusement, le régulateur de la température 6 du liquide 5 dans la cuve 4.

Le circuit de commande général peut être ainsi configuré pour réguler la température de la cellule solaire photovoltaïque 2 à une température ou une plage de température cible, comprise entre 50 et 230 °C, et avantageusement entre 120 et 210 °C. Préférentiellement le circuit de commande général contrôle également la vitesse de déplacement du support 1 dans la cuve 4, et les moyens de brassage.

Comme illustré aux différentes figures, les moyens de génération de porteurs de charges 3 comportent une source lumineuse 3b destinée à éclairer la cellule solaire photovoltaïque 2. La source lumineuse 3b peut comporter des lampes monochromatiques permettant de produire un faisceau lumineux incident ayant une longueur d'onde comprise entre 300 et 1300 nm. La source lumineuse 3b peut également comporter des lampes halogènes ou xénon permettant de produire une lumière blanche. Préférentiellement, la source lumineuse 3b est configurée pour fournir un éclairement intense de manière à ce que les cellules solaires photovoltaïques reçoivent un éclairement supérieur à 0,05 W.cm$^{-2}$. Par ailleurs, la source lumineuse 3b peut comporter une source laser, qui génère avantageusement un éclairement intense. L'utilisation d'une source laser permet avantageusement une réduction de la consommation énergétique, en comparaison avec les autres sources lumineuses.

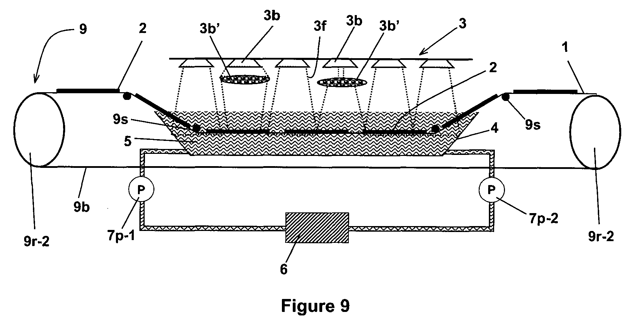

Selon un mode particulier de réalisation illustré à la figure 9, la source lumineuse 3b comporte un système optique 3b' disposé entre les cellules solaires photovoltaïques 2 et la source lumineuse 3b. À titre d'exemple, lorsque la source lumineuse 3b est une source laser, il est avantageux d'utiliser une lentille divergente comme système optique 3b'. Une lentille divergente permet ainsi d'augmenter la surface de la cellule solaire photovoltaïque recevant l'éclairement. Par ailleurs, lorsque la source lumineuse est constituée par une lampe halogène ou une lampe monochromatique, il est avantageux d'utiliser une lentille convergente comme système optique pour concentrer le faisceau lumineux et augmenter l'intensité de l'éclairement reçu par la cellule solaire photovoltaïque 2.

Les procédés classiques de restauration des cellules solaires photovoltaïques sont réalisés en chauffant les cellules dans un four classique (conventionnel ou à plaque chauffante), tout en générant une quantité de porteurs de charge dans les cellules.

Selon un mode particulier de mise en oeuvre d'un procédé de restauration de cellule solaire photovoltaïque à base de silicium, contre les effets de dégradation du rendement sous éclairement, un régime d'ondes ultrasonores stationnaire est généré pour accélérer la cinétique de restauration.

Préférentiellement, le procédé utilise un des dispositifs de restauration décrits ci-dessus, et illustrés aux figures 1 à 8. Le procédé de restauration comporte une étape où l'on prévoit une cellule solaire photovoltaïque 2 réalisée dans un substrat, ou dans une couche active, à base de silicium amorphe, monocristallin ou multicristallin.

Le procédé de restauration comporte une étape de chauffage de la cellule solaire photovoltaïque 2, et une étape de génération de porteurs de charge dans ladite cellule 2. Le procédé comporte également une étape de génération d'un régime d'ondes ultrasonores stationnaire dans la cellule solaire photovoltaïque 2. En outre, un tel procédé peut être avantageusement mis en oeuvre avec une régulation de la température de la cellule solaire photovoltaïque, à une valeur ou une plage de température cible, comprise dans l'intervalle de température 50 °C - 230 °C et avantageusement 120-210°C.

Par ailleurs, la régulation de la température peut être réalisée par une étape où la cellule solaire photovoltaïque 2 est plongée dans un liquide 5 lors de la génération de porteurs de charge dans ladite cellule 2. Préférentiellement, pour réaliser le procédé, on utilise le dispositif de restauration comportant le régulateur de la température 6 du liquide 5.

En fait, suivant le type des moyens de génération 3, par éclairement ou par injection d'un courant électrique, le liquide 5 peut être soit transparent au faisceau lumineux émis, soit électriquement isolant. Préférentiellement, les porteurs de charge sont injectés dans la cellule solaire photovoltaïque 2 par des moyens de génération 3 comportant une source de lumière 3b, et le liquide 5 est transparent au faisceau lumineux 3f émis par ladite source 3b.

Le liquide 5 peut être choisi en fonction de ses propriétés physico-chimiques notamment, l'impédance acoustique, la capacité thermique volumique, la chaleur latente de vaporisation, la conductivité thermique, et la viscosité.

Préférentiellement, le liquide 5 est non toxique et n'affecte pas les performances des cellules solaires photovoltaïques à base de silicium. Par ailleurs, le critère de mouillabilité du liquide 5 sur la cellule solaire photovoltaïque 2 est également un critère susceptible d'être pris en compte. En effet, ce critère peut jouer un rôle pour assurer un transfert thermique efficace entre le liquide 5 et la cellule solaire photovoltaïque 2. Avantageusement, le liquide 5 a un angle de contact, avec ladite cellule 2, inférieur à 90° et préférentiellement de l'ordre de 45°.

Pour réaliser le procédé de restauration, le liquide 5 utilisé pour la régulation de la température de la cellule solaire photovoltaïque est préférentiellement choisi de manière à ne pas s'évaporer au cours du traitement de restauration. Ainsi, le choix du liquide utilisé est intimement lié aux critères cités ci-dessus, mais également à la gamme de température dans laquelle le procédé de restauration est réalisé. Comme décrit ci-dessus, le procédé de restauration est avantageusement réalisé à une température comprise entre 50 °C et 230 °C. Ainsi, de manière avantageuse, le liquide 5 est choisi de manière à avoir une température d'ébullition supérieure strictement à 100 °C, et avantageusement supérieure ou égale à environ 230°C.

À titre d'exemple, le liquide 5 peut être choisi parmi la famille des liquides caloporteurs. Ce type de liquide se distingue par sa facilité à réguler la température de son environnement. Avantageusement, le liquide 5 comporte de l'éthylène glycol ou du glycérol. L'éthylène glycol est un fluide caloporteur, non toxique et qui a une température d'ébullition de 198 °C. Par ailleurs, le glycérol est un liquide non toxique et qui a une température d'ébullition de 290 °C mais, il commence à se décomposer à partir d'une température de 171 °C.

En outre, le liquide 5 peut comporter une huile de coupe soluble, qui comporte notamment une huile minérale, un émulgateur et de l'eau. Les huiles de coupe ont des caractéristiques physiques intéressantes. En effet, les huiles de coupe sont généralement transparentes, et elles ont une viscosité proche de celle de l'eau. De plus, ce type de liquide possède un pouvoir refroidisseur intéressant, et il reste à l'état liquide pour des températures supérieures à 100 °C.

Par ailleurs, le liquide 5 est avantageusement choisi de manière à avoir une impédance acoustique la plus proche possible de celle de la cellule solaire photovoltaïque 2 à base de silicium. Cette condition, concernant l'impédance acoustique du liquide 5, permet un couplage énergétique parfait entre le liquide 5 et ladite cellule 2, générant ainsi une propagation optimale des ondes ultrasonores depuis le transducteur ultrason 20 vers la cellule solaire photovoltaïque 2. En effet, le coefficient de transmission T d'une onde ultrasonore à l'interface entre deux milieux A et B, dépend des impédances acoustiques respectives de ces deux milieux. Le coefficient de transmission T est donné par la relation suivante :

$$T = \frac{I_t}{I_i} = \frac{4 \times Z_A Z_B}{(Z_A + Z_B)^2} \qquad (1)$$

où :

- $I_t$ et $I_i$ représentent respectivement les intensités acoustiques (ou puissances) transmise et incidente ; et
- $Z_A$ et $Z_B$ représentent respectivement les impédances acoustiques des milieux A et B.

La cellule solaire photovoltaïque 2 est réalisée principalement à base de silicium. De ce fait, l'impédance acoustique de ladite cellule 2 peut être sensiblement égale à celle du silicium. Par ailleurs, en considérant que le coefficient de transfert à l'interface entre le transducteur ultrason 20 et le liquide 5 est sensiblement du même ordre que celui à l'interface entre le liquide 5 et ladite cellule 2, la puissance du transducteur peut ainsi être réglée de manière à préciser l'énergie d'origine ultrasonore reçue par la cellule 2.

Afin que la propagation des ondes ultrasonores dans la cellule solaire photovoltaïque puisse agir sur les défauts et complexes d'impuretés, l'énergie « ultrasonore » reçue par ladite cellule 2 est préférentiellement comprise entre 0,1 et 10 W.cm$^{-2}$. De ce fait, la puissance du transducteur ultrason 20 ainsi que le coefficient de transmission des ondes ultrasonores à l'interface entre le liquide 5 et ladite cellule 2, sont avantageusement ajustés de manière à ce que la cellule solaire photovoltaïque à restaurer reçoive une énergie comprise entre 0,1 et 10 W.cm$^{-2}$. En effet, en réglant la puissance du transducteur ultrason, et/ou en choisissant un liquide 5 ayant une impédance acoustique optimale (i.e. permettant d'avoir un coefficient de transmission T maximal à l'interface entre le liquide 5 et ladite cellule 2), l'énergie reçue par la cellule peut être avantageusement fixée à une valeur comprise entre 0,1 et 10W.cm$^{-2}$.

L'impédance acoustique du silicium dépend de son orientation cristallographique et peut être comprise entre $11.10^6$ et $22.10^6$ N.s.m$^{-3}$. À titre d'exemple, en choisissant le glycol ($Z_{glycol} = 2,34.10^6$ N.s.m$^{-3}$) comme liquide 5 de régulation de la température, le coefficient de transmission à l'interface entre le glycol et la cellule solaire photovoltaïque 2 peut être estimée à une valeur comprise entre 0,35 et 0,58. Ainsi, pour que la cellule solaire photovoltaïque 2 reçoive une énergie comprise entre 0,1 et 10 W.cm$^{-2}$, la puissance du transducteur ultrason 20 est avantageusement réglée à une valeur comprise entre 0,3 et 80 W.cm$^{-2}$.

Le procédé de restauration permet avantageusement d'utiliser des ondes ultrasonores, et de relâcher la contrainte sur l'étape de génération des porteurs de charge. Le procédé permet ainsi de favoriser les effets de diffusion, réorientation et dissociation des défauts, et d'augmenter l'intensité de la génération des porteurs dans la cellule, tout en régulant sa température à une température convenable pour obtenir une restauration rapide et efficace.

À titre d'exemple, un dispositif de restauration de cellule solaire photovoltaïque comportant un transducteur ultrason a été réalisé. Les moyens de génération de porteurs de charge sont constitués par des lampes halogènes permettant à la cellule solaire photovoltaïque de recevoir un éclairement d'une intensité de 3 W.cm$^{-2}$. En utilisant des dispositifs classiques de restauration, la température de la cellule solaire photovoltaïque ne peut pas être maintenue en dessous de 145 °C lorsque ladite cellule reçoit une intensité d'éclairement supérieure à quelques dixièmes de W.cm$^{-2}$.

Pour le procédé de restauration, l'éthylène glycol régulé en température a été utilisé pour réguler la température de la cellule traitée à une température sensiblement égale à 145 °C. Le procédé selon l'invention a permis de restaurer la cellule en utilisant un éclairement intense de 3 W.cm$^{-2}$, après seulement 4 minutes de traitement. À titre de comparaison, des procédés de restauration selon le procédé de l'art antérieur ont montré que les mécanismes de guérison ont pris place entre 10 et 40 heures de traitement. Ces essais ont été réalisés en chauffant les cellules à une température comprise entre 150 °C et 180 °C, et un éclairement de 0,1 W.cm$^{-2}$.

Le dispositif et le procédé de restauration décrits ci-dessus peuvent s'appliquer à une ou plusieurs cellules solaires photovoltaïques, qui peuvent être mises en module ou non.

**Revendications**

1. Dispositif de restauration d'au moins une cellule solaire photovoltaïque à base de silicium, comportant :

   - une source de chaleur configurée pour chauffer la cellule solaire photovoltaïque (2) ;
   - des moyens de génération (3) de porteurs de charge dans la cellule solaire photovoltaïque (2) ;

   **caractérisé en ce qu'**il comporte un transducteur ultrason (20) destiné à générer des ondes ultrasonores se propageant dans la cellule solaire photovoltaïque (2).

2. Dispositif selon la revendication 1, **caractérisé en ce que** les moyens de génération (3) de porteurs de charge comportent des moyens d'injection d'un courant électrique dans la cellule solaire photovoltaïque (2).

3. Dispositif selon l'une des revendications 1 et 2, **caractérisé en ce qu'**il comporte des éléments configurés pour réguler la température de la cellule solaire photovoltaïque (2) à une valeur ou une plage de température cible comprise dans l'intervalle de température de 50 °C - 230 °C.

4. Dispositif selon la revendication 3, **caractérisé en ce que** les éléments de régulation de la température de la cellule solaire photovoltaïque (2) comprennent une cuve (4) destinée à être remplie par un liquide (5), et un support (1) de la cellule solaire photovoltaïque (2) configuré pour la disposer dans le liquide (5).

5. Dispositif selon la revendication 4, **caractérisé en ce que** la cuve (4) comporte un régulateur (6) de la température du liquide (5) configuré pour réguler la température de la cellule solaire photovoltaïque (2) à la valeur ou la plage de température cible.

6. Dispositif selon l'une des revendications 4 et 5, **caractérisé en ce qu'**il comporte des moyens de déplacement (9) du support (1) dans la cuve (4) configurés pour faire déplacer la cellule solaire photovoltaïque (2) suivant une direction parallèle à la surface du liquide (6) dans la cuve (4).

7. Dispositif selon l'une quelconque des revendications 4 à 6, **caractérisé en ce que** le transducteur ultrason (20) est disposé dans la cuve (4) et **en ce qu'**il est configuré pour générer un régime d'ondes ultrasonores stationnaire dans le liquide (5) et dans la cellule solaire photovoltaïque (2).

8. Dispositif selon la revendication 1, **caractérisé en ce que** le transducteur ultrason (20) est interposé entre la cellule solaire photovoltaïque (2) et un support (1) de la cellule solaire photovoltaïque (2).

9. Dispositif selon la revendication 1, **caractérisé en ce que** le transducteur ultrason (20) est conformé de manière à recevoir la cellule solaire photovoltaïque (2).

10. Procédé de restauration d'au moins une cellule solaire photovoltaïque (2) à base de silicium contre la dégradation du rendement sous éclairement, **caractérisé en ce qu'**il comporte les étapes suivantes :

    - chauffer la cellule solaire photovoltaïque (2);
    - générer des porteurs de charge dans la cellule solaire photovoltaïque (2); et
    - générer un régime d'ondes ultrasonores stationnaire dans la cellule solaire photovoltaïque (2).

11. Procédé de restauration selon la revendication 10, **caractérisé en ce qu'**il comporte une étape de régulation de la température de la cellule solaire photovoltaïque (2) à une valeur ou une plage de température cible comprise dans l'intervalle 50 °C - 230 °C.

12. Procédé de restauration selon la revendication 11, **caractérisé en ce que** l'étape de régulation de la température de la cellule solaire photovoltaïque (2) est réalisée en plongeant ladite cellule (2) dans un liquide (5) lors de l'étape de génération de porteurs de charge.

13. Procédé de restauration selon la revendication 12, **caractérisé en ce que** le liquide (5) est un liquide ayant une température d'ébullition supérieure strictement à 100 °C.

14. Procédé de restauration selon la revendication 13, **caractérisé en ce que** le liquide (5) comporte de l'éthylène glycol ou du glycérol ou une huile de coupe soluble.

**Patentansprüche**

1. Vorrichtung zur Wiederherstellung wenigstens einer photovoltaischen Solarzelle auf Siliciumbasis, umfassend:

    - eine Wärmequelle, die dazu ausgelegt ist, die photovoltaische Solarzelle (2) zu erwärmen;
    - Mittel zur Erzeugung (3) von Ladungsträgern in der photovoltaischen Solarzelle (2);

    **dadurch gekennzeichnet, dass** sie einen Ultraschallwandler (20) umfasst, der dazu bestimmt ist, sich in der photovoltaischen Solarzelle (2) ausbreitende Ultraschallwellen zu erzeugen.

2. Vorrichtung nach Anspruch 1, **dadurch gekennzeichnet, dass** die Mittel zur Erzeugung (3) von Ladungsträgern Mittel zum Einleiten eines elektrischen Stroms in die photovoltaische Solarzelle (2) umfassen.

3. Vorrichtung nach einem der Ansprüche 1 und 2, **dadurch gekennzeichnet, dass** sie Elemente umfasst, die dazu ausgelegt sind, die Temperatur der photovoltaischen Solarzelle (2) auf einen Zieltemperaturwert oder -bereich, der innerhalb der Temperaturspanne von 50 °C bis 230 °C gelegen ist, zu regeln.

4. Vorrichtung nach Anspruch 3, **dadurch gekennzeichnet, dass** die Elemente zur Regelung der Temperatur der photovoltaischen Solarzelle (2) eine Wanne (4), die dazu bestimmt ist, mit einer Flüssigkeit (5) gefüllt zu werden, und einen Halter (1) für die photovoltaische Solarzelle (2), der dazu ausgelegt ist, sie in der Flüssigkeit (5) anzuordnen, umfassen.

5. Vorrichtung nach Anspruch 4, **dadurch gekennzeichnet, dass** die Wanne (4) einen Regler (6) für die Temperatur der Flüssigkeit (5) umfasst, der dazu ausgelegt ist, die Temperatur der photovoltaischen Solarzelle (2) auf den Zieltemperaturwert oder - bereich zu regeln.

6. Vorrichtung nach einem der Ansprüche 4 und 5, **dadurch gekennzeichnet, dass** sie Mittel zum Bewegen (9) des Halters (1) in der Wanne (4) umfasst, die dazu ausgelegt sind, die photovoltaische Solarzelle (2) in einer Richtung parallel zur Oberfläche der Flüssigkeit (5) in der Wanne (4) bewegen zu lassen.

7. Vorrichtung nach einem der Ansprüche 4 bis 6, **dadurch gekennzeichnet, dass** der Ultraschallwandler (20) in der Wanne (4) angeordnet ist und dass er dazu ausgelegt ist, einen stationären Ultraschallwellenzustand in der Flüssigkeit (5) und in der photovoltaischen Solarzelle (2) zu erzeugen.

8. Vorrichtung nach Anspruch 1, **dadurch gekennzeichnet, dass** der Ultraschallwandler (20) zwischen der photovoltaischen Solarzelle (2) und einem Halter (1) für die photovoltaische Solarzelle (2) eingefügt ist.

9. Vorrichtung nach Anspruch 1, **dadurch gekennzeichnet, dass** der Ultraschallwandler (20) so ausgestaltet ist, dass er die photovoltaische Solarzelle (2) aufnimmt.

10. Verfahren zur Wiederherstellung wenigstens einer photovoltaischen Solarzelle (2) auf Siliciumbasis, gegen eine Degradation des Wirkungsgrades unter Bestrahlung, **dadurch gekennzeichnet, dass** es die folgenden Schritte umfasst:

   - Erwärmen der photovoltaischen Solarzelle (2);
   - Erzeugen von Ladungsträgern in der photovoltaischen Solarzelle (2); und
   - Erzeugen eines stationären Ultraschallwellenzustandes in der photovoltaischen Solarzelle (2).

11. Wiederherstellungsverfahren nach Anspruch 10, **dadurch gekennzeichnet, dass** es einen Schritt zur Regelung der Temperatur der photovoltaischen Solarzelle (2) auf einen Zieltemperaturwert oder -bereich innerhalb der Spanne von 50 °C bis 230 °C umfasst.

12. Wiederherstellungsverfahren nach Anspruch 11, **dadurch gekennzeichnet, dass** der Schritt zur Regelung der Temperatur der photovoltaischen Solarzelle (2) dadurch vollzogen wird, dass die Zelle (2) während des Schrittes zur Erzeugung von Ladungsträgern in eine Flüssigkeit (5) eingetaucht wird.

13. Wiederherstellungsverfahren nach Anspruch 12, **dadurch gekennzeichnet, dass** die Flüssigkeit (5) eine Flüssigkeit mit einer Siedetemperatur streng oberhalb von 100 °C ist.

14. Wiederherstellungsverfahren nach Anspruch 13, **dadurch gekennzeichnet, dass** die Flüssigkeit (5) Ethylenglykol oder Glycerin oder ein lösliches Schneidöl umfasst.

## Claims

1. A restoration device of at least one silicon-based photovoltaic solar cell, comprising:

   - a heat source configured to heat the photovoltaic solar cell (2);
   - means (3) for generating charge carriers in the photovoltaic solar cell (2);

   **characterized in that** it comprises an ultrasonic transducer (20) designed to generate ultrasonic waves propagating in the photovoltaic solar cell (2).

2. The device according to claim 1, **characterized in that** the charge carrier generating means (3) comprise means for injecting an electric current into the photovoltaic solar cell (2).

3. The device according to one of claims 1 and 2, **characterized in that** it comprises elements configured to regulate the temperature of the photovoltaic solar cell (2) to a target temperature value or range comprised in the 50 °C - 230 °C range.

4. The device according to claim 3, **characterized in that** the elements for regulating the temperature of the photovoltaic solar cell (2) comprise a tank (4) designed to be filled by a liquid (5), and a support (1) of the photovoltaic solar cell (2) configured to place it in the liquid (5).

5. The device according to claim 4, **characterized in that** the tank (4) comprises a regulator (6) of the temperature of the liquid (5) configured to regulate the temperature of the photovoltaic solar cell (2) to the target temperature value or range.

6. The device according to one of claims 4 and 5, **characterized in that** it comprises movement means (9) of the support (1) in the tank (4) configured to make the photovoltaic solar cell (2) move in a direction parallel to the surface of the liquid (6) in the tank (4).

7. The device according to any one of claims 4 to 6, **characterized in that** the ultrasonic transducer (20) is arranged in the tank (4) and **in that** it is configured to generate a stationary regime of ultrasonic waves in the liquid (5) and in the photovoltaic solar cell (2).

8. The device according to claim 1, **characterized in that** the ultrasonic transducer (20) is placed between the photovoltaic solar cell (2) and a support (1) of the photovoltaic solar cell (2).

9. The device according to claim 1, **characterized in that** the ultrasonic transducer (20) is shaped in such a way as to receive the photovoltaic solar cell (2).

10. A restoration method of at least one silicon-based photovoltaic solar cell (2) to counteract degradation of the efficiency under illumination, **characterized in that** it comprises the following steps:

    - heating the photovoltaic solar cell (2);
    - generating charge carriers in the photovoltaic solar cell (2); and
    - generating a stationary regime of ultrasonic waves in the photovoltaic solar cell (2).

11. The restoration method according to claim 10, **characterized in that** it comprises a regulation step of the temperature of the photovoltaic solar cell (2) to a target temperature value or range comprised in the 50 °C - 230 °C range.

12. The restoration method according to claim 11, **characterized in that** the regulation step of the temperature of the photovoltaic solar cell (2) is performed by immersing said cell (2) in a liquid (5) when the charge carrier generation step is performed.

13. The restoration method according to claim 12, **characterized in that** the liquid (5) is a liquid having a boiling temperature strictly higher than 100 °C.

14. The restoration method according to claim 13, **characterized in that** the liquid (5) comprises ethylene glycol or glycerol or a soluble cutting oil.

**Figure 1**

**Figure 2**

Figure 3

Figure 4

Figure 5

Figure 6

**Figure 7A**

**Figure 7B**

**Figure 8**

**Figure 9**

**EP 2 896 076 B1**

## RÉFÉRENCES CITÉES DANS LA DESCRIPTION

**Documents brevets cités dans la description**

- WO 2007107351 A
- CN 201450015